# EUROPÄISCHE PATENTSCHRIFT

(11) **EP 4 150 668 B1**
(45) Veröffentlichungstag und Bekanntmachung des Hinweises auf die Patenterteilung: **24.07.2024**
(21) Anmeldenummer: 21735221.0
(22) Anmeldetag: 18.06.2021
(51) Int. Cl.: H01L 23/373, H01L 21/48, H01L 23/045, H01L 23/047, H01L 25/07, H01L 25/16, H01L 25/18, H01L 23/367

(54) **HALBLEITERMODUL MIT EINEM KÜHLKÖRPER**
SEMICONDUCTOR MODULE WITH A COOLING BODY
MODULE SEMI-CONDUCTEUR DOTÉ D'UN DISSIPATEUR THERMIQUE

(30) Priorität: 26.08.2020 EP 20192898
(43) Veröffentlichungstag der Anmeldung: 22.03.2023
(73) Patentinhaber: Siemens Aktiengesellschaft, 80333 München (DE)
(72) Erfinder: SCHIERLING, Hubert, 91052 Erlangen (DE); SCHMENGER, Jens, 91301 Forchheim (DE)
(74) Vertreter: Siemens Patent Attorneys
(86) Internationale Anmeldenummer: PCT/EP2021/066540
(87) Internationale Veröffentlichungsnummer: WO 2022/042895

(56) Entgegenhaltungen:
- WO-A1-2011/024377
- US-A1- 2005 006 054

## Beschreibung

Die Erfindung betrifft einen Kühlkörper mit einer Montageoberfläche zum Anordnen von wenigstens einem Halbleiterelement, wobei in der Montageoberfläche wenigstens eine offene Nut ausgebildet ist. Darüber hinaus betrifft die Erfindung ein Halbleitermodul für einen elektrischen Energiewandler mit einem Kühlkörper und einem auf einer Montageoberfläche des Kühlkörpers angeordneten Halbleiterelement. Schließlich betrifft die Erfindung auch ein Verfahren zum Herstellen eines Halbleitermoduls.

Kühlkörper, Halbleitermodule sowie Verfahren zu deren Herstellung sind aus dem Stand der Technik umfänglich bekannt, sodass es eines gesonderten druckschriftlichen Nachweises hierfür nicht bedarf. Kühlkörper und Halbleitermodule werden im Stand der Technik vielfältig eingesetzt, um elektrische Energie auf unterschiedlichste Weise umzuformen. Die Umformung der elektrischen Energie wird in der Regel mittels eines Energiewandlers durchgeführt, der zum Beispiel als Wechselrichter, Umrichter, DC/DC-Wandler oder dergleichen ausgebildet sein kann. Der Wechselrichter ist eine Form eines Energiewandlers, der einen Gleichspannungszwischenkreis mit einem Wechselspannungsnetz energietechnisch koppelt, sodass zwischen dem Gleichspannungszwischenkreis und dem Wechselspannungsnetz elektrische Energie ausgetauscht werden kann. Zu diesem Zweck ist in der Regel vorgesehen, dass der Energiewandler wenigstens ein Schaltelement aufweist, das mit elektrischen Energiespeichern zusammenwirkt. Das wenigstens eine Schaltelement ist in der Regel durch zumindest ein Halbleitermodul gebildet, das ein oder mehrere Halbleiterschaltelemente umfassen kann. Ein Umrichter koppelt dagegen zwei Wechselspannungsnetze miteinander. Darüber hinaus kann der Energiewandler auch ein DC/DC-Wandler sein, der zwei Gleichspannungsnetze miteinander energietechnisch koppelt.

Das Wechselspannungsnetz kann zum Beispiel durch ein Wechselspannungsversorgungsnetz oder auch eine elektrische Maschine gebildet sein, insbesondere eine mehrphasige elektrische Maschine. Durch Steuern des wenigstens einen Schaltelements mittels einer Steuereinheit im Schaltbetrieb kann die gewünschte Wandlungsfunktion des Wechselrichters beziehungsweise des Energiewandlers beziehungsweise des Umrichters erreicht werden, sodass mit der elektrischen Maschine die gewünschte Antriebsfunktion erreicht werden kann.

Die Schaltelemente beziehungsweise Halbleiterschaltelemente werden zu diesem Zweck gewöhnlich mit einer vorgegebenen hohen Taktrate in einem Schaltbetrieb betrieben, die erheblich größer als eine Frequenz von wenigstens einer Phasenwechselspannung des Wechselspannungsnetzes ist. Mittels bestimmter Steuerungsverfahren, beispielsweise Pulsweitenmodulation (PWM) oder dergleichen, kann dann die gewünschte energietechnische Kopplung hergestellt werden. Zu diesem Zweck stellt die Steuereinheit für das wenigstens eine Schaltelement beziehungsweise jedes der Schaltelemente spezifische Schaltsignale bereit, sodass das wenigstens eine Schaltelement beziehungsweise die Schaltelemente im Schaltbetrieb in gewünschter Weise betrieben werden können.

Im bestimmungsgemäßen Betrieb zeigt sich, dass die Schaltelemente, die durch Halbleiterelemente der Halbleitermodule gebildet sind, insbesondere nach Art von Leistungsmodulen, thermisch hoch beansprucht sind. Die Beanspruchung ist abhängig von der umgesetzten Leistung, der Taktrate, einer Kühlung, die in der Regel mittels des Kühlkörpers erreicht wird, sowie gegebenenfalls weiteren Effekten.

Das Halbleiterelement ist ein elektronisches Bauteil, welches dazu dient, eine vorgegebene Funktionalität innerhalb einer elektronischen Hardwareschaltung realisieren zu können. Zu diesem Zweck weist das Halbleitermodul wenigstens ein Halbleiterelement auf. Das Halbleitermodul weist zu diesem Zweck ferner einen oder mehrere elektrische Anschlusskontakte auf, mittels denen es elektrisch an eine elektronische Hardwareschaltung angeschlossen sein kann.

Das Halbleitermodul umfasst zumindest das wenigstens eine Halbleiterelement, welches die physikalische, insbesondere elektrische, Funktionalität des Halbleitermoduls bereitstellt. Das Halbleiterelement ist in der Regel durch einen Halbleiterkristall gebildet, der durch physikalische und/oder chemische Behandlung hinsichtlich seines kristallinen Aufbaus ausgestaltet ist, eine vorgegebene Funktionalität realisieren zu können. Eine solche Funktionalität kann zum Beispiel ein Transistor, eine Diode, ein Thyristor, Kombinationsschaltungen hiervon, beispielsweise auch unter Realisierung von passiven elektronischen Bauteilen wie elektrischen Widerständen, elektrischen Kondensatoren und/oder dergleichen sein. Das Halbleiterelement kann somit die Funktion eines Transistors realisieren, beispielsweise ein bipolarer Transistor, ein Feldeffekttransistor, insbesondere ein Metal-Oxide-Semiconductor-Field-Effect-Transistor (MOSFET), ein Insulated-Gate-Bipolar-Transistor (IGBT) und/oder dergleichen. Darüber hinaus kann das Halbleitermodul auch einen Thyristor realisieren, beispielsweise einen TRIAC, einen Gate-Turn-Off-Thyristor (GTO) und/oder dergleichen. Diese Funktionalitäten können natürlich auch in nahezu beliebiger Weise kombiniert durch das Halbleitermodul bereitgestellt werden, insbesondere um weitere ergänzende Funktionalitäten bereitstellen zu können.

Das Halbleiterelement kann zum Beispiel einen bipolaren Transistor realisieren, der mittels einer ergänzend integrierten Diode eine Freilauffunktion realisiert, wenn der Transistor reversiert mit elektrischer Spannung beaufschlagt wird. Das Halbleiterelement weist in der Regel einen entsprechend ausgebildeten Halbleiterchip auf, der über ein Substrat mit einer Montage- und Kühlplatte des Halbleitermoduls mechanisch verbunden ist. Die Kühlplatte des Halbleitermoduls dient dazu, an einem Kühlkörper beziehungsweise seiner Montageoberfläche befestigt zu werden, sodass im bestimmungsgemäßen Betrieb des Halbleitermoduls beziehungsweise des wenigstens einen Halbleiterelements auftretende Wärme über den Kühlkörper abgeführt werden kann.

An der Kühl- und Montageplatte ist ferner in der Regel ein Gehäuse befestigt, das das wenigstens eine Halbleiterelement vor äußeren Einwirkungen schützt und der elektrische Anschlusskontakte aufweist, die mit entsprechenden Kontaktflächen zum Anschließen des wenigstens einen Halbleiterelements elektrisch verbunden sind. Die Anschlusskontakte dienen dazu, eine elektrische Verbindung zu der Hardwareschaltung herzustellen. Die Anschlusskontakte können nach Art von Stiften zum Verbinden beziehungsweise Montieren auf einer Leiterplatte und/oder auch als Schraub- oder Klemmverbindungen ausgebildet sein, die beispielsweise mit Stromschienen oder dergleichen verbunden sein können.

Aus der EP 3 624 184 A1 ist bereits ein Verfahren zur Herstellung einer Leistungsmoduleinheit sowie eine Leistungsmoduleinheit, ein Netzteil und ein Frequenzumrichter bekannt. Um die Kühlung der Halbleiterelemente zu verbessern, schlägt diese Lehre vor, das Substrat mit dem Leistungshalbleiter direkt auf eine Grundplatte aufzubringen, um eine Materialgrenze zwischen der Grundplatte und dem Kühlkörper zu ersetzen. Dadurch soll die thermische Anbindung des Halbleiters an den Kühlkörper verbessert werden. Die Verbindung soll mittels Erwärmung in einem Ofen hergestellt werden. Daher schlägt die Lehre der EP 3 624 184 A1 vor, Kühlrippen des Kühlkörpers nach der Befestigung des Substrats in entsprechenden Aussparungen der Grundplatte zu befestigen.

Darüber hinaus offenbart die DE 10 2018 207 745 A1 einen Kühlkörper und eine Kühlkörperbaugruppe. Diese Lehre soll einen Kühlkörper und eine Kühlkörperbaugruppe bereitstellen, die zur effizienten Abgabe von Wärme in der Lage sind, die sich auf einen Chipbereich eines Leistungs-Halbleitervorrichtungsmoduls konzentriert. Der Kühlkörper soll einen Wärmeableitungs-Strukturbereich mit einer höheren Wärmeleitfähigkeit als diejenige eines Kühlkörperkorpus aufweisen und dadurch die Wärme ableiten.

Die Offenlegungsschrift US 2005/0006054 A1 beschreibt einen Kühlkörper für eine Halbleitervorrichtung umfassend eine Basis, die eine erste Oberfläche, auf der eine Vielzahl von wärmeabstrahlenden Rippen angeordnet sind, und eine zweite Oberfläche, die die Halbleitervorrichtung direkt berührt, aufweist. Auf der zweiten Oberfläche des Sockels ist ein Wärmeverteiler so vorgesehen, dass dieser die Halbleitervorrichtung nicht direkt berührt.

Die Offenlegungsschrift WO 2011/024377 A1 beschreibt ein Wärmestrahlungselement mit einem aluminiumhaltigen Element und einem kupferhaltigen Element, das in das aluminiumhaltige Element eingebettet ist und dessen Seiten von dem aluminiumhaltigen Element umschlossen sind. Ein Halbleiterelement wird thermisch mit dem Wärmestrahlungselement verbunden, um ein Halbleitermodul herzustellen. Das Wärmestrahlungselement umfasst das Aluminiumelement und das Kupferelement. Dadurch ist es möglich, ein geringes Gewicht zu realisieren und gleichzeitig eine sichere Wärmeabstrahlung zu gewährleisten. Darüber hinaus ist das Kupferelement von dem Aluminiumelement umschlossen. Dementsprechend kann die Festigkeit des Wärmestrahlungselements erhöht werden.

Auch wenn sich der Stand der Technik dem Grund nach bewährt hat, so verbleiben dennoch Nachteile.

Halbleitermodule, die für große elektrische Ströme ausgebildet sind, beispielsweise größer als etwa 1 A, insbesondere größer als etwa 10 A, weisen in der Regel Schraubverbindungen als Anschlusskontakte auf, die an einem Gehäuse des Halbleitermoduls angeordnet sind. An den Schraubverbindungen können beispielsweise Metallschienen als Stromschienen oder auch Gewindebolzen aus Metall für den elektrischen Anschluss angeschlossen werden. Zugleich ist das Halbleitermodul auch dazu ausgebildet, auf einer Leiterplatte bestückt zu werden, zu welchem Zweck entsprechende Anschlussstifte vorgesehen sind, die in entsprechende Durchgangsöffnungen der Leiterplatte eingesteckt und dort verlötet oder auch eingepresst sein können. Dadurch ergibt sich eine Montagereihenfolge für die Schaltungsanordnung, bei der das Halbleitermodul zunächst mit den Anschlussstiften mit der Leiterplatte verbunden wird, die hierdurch gebildete Baugruppe gewendet und über einem Kühlkörper positioniert wird. Anschließend wird das Halbleitermodul mittels der Schraubverbindungen mit der Leiterplatte und dem Kühlkörper sowie mit den Schraubbolzen beziehungsweise Metallschienen verschraubt.

Diese Vorgehensweise hat zur Folge, dass, insbesondere durch die vielen Bohrungen, besonders die, die der Schraubbefestigung dienen, viel Leiterplattenfläche im Bereich des Halbleitermoduls beansprucht wird. Dadurch ergibt sich der Nachteil, dass Leiterbahnquerschnitte auf der Leiterplatte reduziert werden müssen oder Leiterbahnen ungünstig geführt werden müssen und Fläche für die Positionierung von elektronischen Bauelementen reduziert wird.

Dabei erweist es sich unter anderem als Problem, dass die Anschlusskontakte, die nach Art von Schraubverbindungen ausgebildet sind, in der Regel an Stirnseiten des Halbleitermoduls beziehungsweise dessen Gehäuse angeordnet sind. Aus konstruktiven Gründen ist dies beim Stand der Technik auch nicht anders möglich. Die Konstruktion der Halbleitermodule im Stand der Technik lässt lediglich eine Kontaktierung von einer Oberseite des Halbleitermoduls zu, die der Kühlflächenseite gegenüberliegend angeordnet ist. Der Bauraum im Bereich des Halbleitermoduls kann nicht für die Anordnung von weiteren Bauelementen genutzt werden.

Der Erfindung liegt somit die Aufgabe zugrunde, einen Kühlkörper, ein Halbleitermodul sowie wie ein Verfahren zu deren Herstellung dahingehend weiterzubilden, dass ein elektrischer Anschluss des Halbleitermoduls flexibler realisiert werden kann.

Als Lösung werden mit der Erfindung ein Kühlkörper, ein Halbleitermodul sowie ein Verfahren gemäß den unabhängigen Ansprüchen vorgeschlagen.

Vorteilhafte Weiterbildungen ergeben sich durch Merkmale der abhängigen Ansprüche.

In Bezug auf einen gattungsgemäßen Kühlkörper wird mit der Erfindung insbesondere vorgeschlagen, dass wenigstens eine wenigstens einen Anschlussbereich zum Anschließen des wenigstens einen Halbleiterelements aufweisende elektrische Leitung, die zumindest teilweise in der wenigstens einen Nut angeordnet ist.

In Bezug auf ein gattungsgemäßes Halbleitermodul wird mit der Erfindung insbesondere vorgeschlagen, dass der Kühlkörper gemäß der Erfindung ausgebildet ist und das Halbleiterelement an die wenigstens eine elektrische Leitung des Kühlkörpers angeschlossen ist.

In Bezug auf ein gattungsgemäßes Verfahren wird mit der Erfindung insbesondere vorgeschlagen, dass ein Kühlkörper mit einer Montageoberfläche zum Anordnen von wenigstens einem Halbleiterelement und mit wenigstens einer in der Montageoberfläche eingebrachten Nut bereitgestellt wird, das wenigstens eine Halbleiterelement mit der Montageoberfläche verbunden wird, die wenigstens eine elektrische Leitung in die wenigstens eine Nut eingebracht wird, ein das wenigstens eine Halbleiterelement umfassender Rahmen auf der Montageoberfläche angeordnet wird, das wenigstens eine Halbleiterelement an die wenigstens eine elektrische Leitung angeschlossen wird, und im Rahmen eine Vergussmasse angeordnet wird.

Die Erfindung basiert unter anderem auf dem Gedanken, dass der Kühlkörper zumindest teilweise eine Leitungsführung, insbesondere im Bereich der in der Regel mit großen elektrischen Strömen beaufschlagten elektrischen Leitungen zu übernehmen vermag. Zugleich kann der Kühlkörper in das Halbleitermodul zumindest teilweise integriert sein, sodass eine kompakte Baueinheit als Halbleitermodul bereitgestellt werden kann, bei der die im Stand der Technik vorliegenden Beschränkungen hinsichtlich der Anordnung der Anschlusskontakte des Halbeitermoduls weitgehend vermieden werden können. Die Erfindung ermöglicht es somit, eine hohe Flexibilität bei der Gestaltung des Halbleitermoduls in Verbindung mit dem Kühlkörper zu realisieren, sodass die eingangs beschriebenen Nachteile zumindest teilweise überwunden werden können. Darüber hinaus kann Bauraum eingespart werden.

Zu diesem Zweck stellt der Kühlkörper die zumindest teilweise, vorzugsweise vollständig, in die Montageoberfläche eingebrachte wenigstens eine elektrische Leitung bereit, sodass die komplexe Leitungsführung im Stand der Technik vorzugsweise weitgehend vermieden, zumindest jedoch reduziert werden kann. Die elektrische Leitung kann durch einen elektrisch gut leitenden Werkstoff gebildet sein, der in der Nut angeordnet ist. Vorzugsweise füllt die elektrische Leitung die wenigstens eine offene Nut im Wesentlichen vollständig aus. Besonders vorteilhaft ist vorgesehen, dass die elektrische Leitung Nutenwände vorzugsweise thermisch gut leitfähig kontaktiert, um so zugleich auch zur thermischen Leitfähigkeit des Kühlkörpers beitragen zu können. Durch die Anordnung der wenigstens einen elektrischen Leitung in der Nut des Kühlkörpers braucht daher die thermische Eigenschaft des Kühlkörpers nicht wesentlich beeinträchtigt zu sein. Vielmehr besteht sogar die Möglichkeit, durch einen geeigneten Werkstoff die thermische Leitfähigkeit sogar noch zu verbessern, beispielsweise wenn in einen Kühlkörper, der aus einer Aluminiumlegierung besteht, eine elektrische Leitung mit einem Werkstoff aus Kupfer eingebracht ist. Alternativ oder ergänzend kann die elektrische Leitung mit einer kleineren Querschnittsfläche und damit zu geringeren Kosten realisiert werden, weil die dadurch bedingten höheren Verluste in Bezug auf die Leitung des elektrischen Stroms über den Kühlkörper abgeführt werden können.

Die wenigstens eine elektrische Leitung weist zumindest einen Anschlussbereich auf, der dem Anschließen des wenigstens einen Halbleiterelements dient. Der Anschluss des Halbleiterelements an den Anschlussbereich kann mittels Bonding, direktem Kontakt, Löten, Schweißen und/oder dergleichen realisiert sein. Darüber hinaus kann die wenigstens eine elektrische Leitung natürlich auch weitere Anschlussbereiche aufweisen, um weitere Halbleiterelemente und/oder elektronische Bauteile anschließen zu können.

Durch die Erfindung ist es also möglich, wenigstens eine Verdrahtungsebene zumindest teilweise in den Kühlkörper hinein zu verlagern, wodurch eben auch erreicht werden kann, dass Anschlusskontakte des Halbleitermoduls an nahezu beliebigen geeigneten Stellen ausgebildet sein können. Die im Stand der Technik vorhandenen Anordnungsbeschränkungen können dadurch weitgehend vermieden werden.

Dadurch kann nicht nur erreicht werden, dass die Anschlusssituation für das Halbleitermodul in Verbindung mit dem Kühlkörper deutlich verbessert wird, sondern es kann auch eine deutlich kompaktere Bauform des Halbleitermoduls erreicht werden.

Durch die Integration zumindest eines Teils des Kühlkörpers in das Halbleitermodul kann darüber hinaus auch eine verbesserte Wärmeleitung erreicht werden, weil ein Substrat, welches das Halbleiterelement trägt, direkt mit der Montageoberfläche des Kühlkörpers verbunden sein kann, beispielsweise mittels Löten, Kleben, Schweißen und/oder dergleichen. Infolgedessen braucht auch keine Kraft mehr unmittelbar am Halbleitermodul durch eine Verschraubung aufgebracht zu werden. Anschraubpunkte können folglich vermieden beziehungsweise in einen Bereich angeordnet werden, der entfernt von dem wenigstens einen Halbleiterelement ist. Dadurch kann das Halbleitermodul auch an einer anderen Seite als seiner Oberseite angeschlossen werden. Die Erfindung ermöglicht somit zugleich auch eine direkte Kontaktierung innerhalb des Halbleitermoduls.

Das Halbleiterelement umfasst in der Regel neben einem Halbleiterkristall, der das entsprechende Funktionselement bereitstellt, vorzugsweise auch ein Substrat, mit dem der Halbleiterkristall, vorzugsweise stoffschlüssig, verbunden ist. Über das Substrat, beziehungsweise einer Substratoberfläche, die der kristallseitigen Oberfläche des Substrats für den Halbleiterkristall gegenüberliegt, kann die mechanische Verbindung zum Kühlkörper realisiert sein. Auch diese Verbindung kann stoffschlüssig ausgebildet sein, beispielsweise mittels Löten, Schweißen oder dergleichen.

Das Halbleitermodul mit dem zumindest teilweise integrierten Kühlkörper kann dadurch hergestellt werden, dass der Kühlkörper mit der Montageoberfläche zum Anordnen des wenigstens einen Halbleiterelements bereitgestellt wird, wobei in der Montageoberfläche wenigstens eine Nut eingebracht ist. Das wenigstens eine Halbleiterelement wird mit der Montageoberfläche verbunden, beispielsweise indem es mittels Löten, Schwei-ßen, Kleben oder dergleichen verbunden wird. Sodann wird die wenigstens eine elektrische Leitung in die wenigstens eine Nut eingebracht. Je nach Bedarf kann jedoch die elektrische Leitung auch vor dem Verbinden des Halbleiterelements mit der Montageoberfläche in die Nut eingebracht sein. Sodann wird ein das wenigstens eine Halbleiterelement umfassender Rahmen auf der Montageoberfläche angeordnet, beispielsweise aufgeklebt oder dergleichen. Das wenigstens eine Halbleiterelement wird an die wenigstens eine elektrische Leitung angeschlossen. Schließlich wird im Rahmen eine Vergussmasse angeordnet, beispielsweise Epoxy oder dergleichen. Das Anschließen des Halbleiterelements an die elektrische Leitung kann mittels Schrauben, Ultraschallschweißen, Bonden und/oder dergleichen realisiert sein.

Gemäß einer Weiterbildung wird vorgeschlagen, dass der Anschlussbereich wenigstens eine Kontaktfläche oder ein Anschlusskontaktelement aufweist. Dadurch kann erreicht werden, dass eine Kontaktierung der elektrischen Leitung zuverlässig realisiert werden kann. Die Kontaktfläche kann zum Beispiel entsprechend des Kontaktierungsverfahrens angepasst ausgebildet sein. Beispielsweise kann sie für ein Bonden ausgebildet sein. Darüber hinaus kann der Anschlussbereich natürlich auch ein oder mehrere Anschlusskontaktelemente aufweisen, die zum Herstellen einer elektrischen Verbindung geeignet sind, beispielsweise eine Klemme, eine Schraubklemme, ein Lötbolzen und/oder dergleichen. Zum elektrischen Kontaktieren kann vorgesehen sein, dass der Anschlussbereich entsprechend ausgebildet ist. Beispielsweise kann vorgesehen sein, wenn vorgesehen ist, dass ein Anschluss mittels Löten erfolgen soll, dass der Anschlussbereich eine Nickelschicht oder dergleichen aufweist.

Vorzugsweise schließt die elektrische Leitung zumindest teilweise bündig mit der Montageoberfläche ab. Dadurch kann eine einheitliche, im Wesentlichen durchgängige Montageoberfläche erreicht werden. Dies erlaubt es, das wenigstens eine Halbleiterelement zumindest auch in einem Bereich anzuordnen, in dem die elektrische Leitung in der Nut angeordnet ist. Die Flexibilität kann somit weiter erhöht werden.

Gemäß einer Weiterbildung wird vorgeschlagen, dass Außenabmessungen der wenigstens einen elektrischen Leitung zumindest teilweise an Innenabmessungen der wenigstens einen Nut angepasst ausgebildet sind. Dadurch kann erreicht werden, dass die elektrische Leitung zumindest indirekt Wände der Nut kontaktieren kann, um so thermisch an den Kühlkörper angekoppelt zu werden. Darüber hinaus kann erreicht werden, dass die elektrische Leitung in der Nut fixiert angeordnet ist, sodass es gesonderter Befestigungsmittel zum Fixieren der Leitung in der Nut dem Grunde nach nicht bedarf.

Vorzugsweise weist die Nut an ihrer Oberfläche eine elektrisch isolierende Schicht auf. Die elektrisch isolierende Schicht ermöglicht es, eine elektrische Isolation zwischen dem Kühlkörper und der elektrischen Leitung herzustellen. Dies ist insbesondere für den Fall vorteilhaft, wenn sich die elektrische Leitung auf einem anderen elektrischen Potential als der Kühlkörper befindet. Eine elektrisch isolierende Schicht braucht jedoch nicht vorgesehen zu sein, wenn der Werkstoff des Kühlkörpers bereits elektrisch isolierende Eigenschaften aufweist. Ein solcher Werkstoff ist zum Beispiel Aluminiumoxid.

Ferner wird vorgeschlagen, dass die wenigstens eine elektrische Leitung eine elektrisch isolierende Schicht aufweist. Dadurch kann erreicht werden, dass die elektrische Leitung auch in einem Bereich eine elektrische Isolierung aufweisen kann, der nicht die Nut beziehungsweise eine Wand der Nut kontaktiert. Natürlich kann auch eine Kombination mit der elektrisch isolierenden Schicht der Nut vorgesehen sein.

Weiterhin wird vorgeschlagen, dass zwischen der wenigstens einen Nut und der wenigstens einen elektrischen Leitung zumindest teilweise ein elektrisches Isolationselement angeordnet ist. Das elektrische Isolationselement kann ein separates Element sein, welches zwischen der elektrischen Leitung und der Wand der Nut angeordnet ist. Das Isolationselement kann zum Beispiel aus einem Kunststoff, einem Keramikwerkstoff und/oder dergleichen gebildet sein, der lediglich eine geringe elektrische Leitfähigkeit aufweist. Diese Ausgestaltung eignet sich zum Beispiel für Anwendungen, bei denen zwischen der elektrischen Leitung und dem Kühlkörper eine große elektrische Spannung anliegt, beispielsweise eine elektrische Spannung von etwa 500 V oder sogar mehr.

Darüber hinaus wird vorgeschlagen, dass das Isolationselement und/oder die elektrisch isolierende Schicht zumindest teilweise bündig mit der Montageoberfläche abschließt. Dadurch kann erreicht werden, dass das Isolationselement beziehungsweise die elektrisch isolierende Schicht nicht über die Montageoberfläche herausragt. Die Montageoberfläche kann dadurch im Wesentlichen vollständig für die Anordnung des wenigstens einen Halbleiterelements und/oder weiterer elektronischer Bauteile verfügbar gehalten werden.

Gemäß einer Weiterbildung wird vorgeschlagen, dass das Isolationselement und/oder die elektrisch isolierende Schicht aus einem thermisch gut leitfähigen Werkstoff gebildet ist. Ein solcher Werkstoff kann zum Beispiel Aluminiumoxid, Bornitrid oder dergleichen aufweisen. Dadurch kann eine gute thermische Kopplung zwischen der wenigstens einen elektrischen Leitung und dem Kühlkörper erreicht werden. Insbesondere kann die Nutzung der elektrischen Leitung zum Führen von Wärme verbessert werden. Durch die wenigstens eine Nut in der Montageoberfläche des Kühlkörpers braucht demnach also keine Barriere in Bezug auf die thermische Leitfähigkeit zu entstehen. Dadurch kann die Erfindung eine negative Auswirkung auf die Kühlfunktion des Kühlkörpers weitgehend vermeiden, insbesondere wenn zugleich auch die wenigstens eine elektrische Leitung eine gute thermische Leitfähigkeit bereitstellt.

Bezüglich des Halbleitermoduls wird ferner vorgeschlagen, dass das Halbleiterelement zumindest teilweise im Bereich der elektrischen Leitung angeordnet ist. Dadurch kann nicht nur die Anschlusssituation für das Halbleiterelement verbessert werden, sondern es kann auch zusätzliche Flexibilität in Bezug auf das Anordnen des wenigstens einen Halbleiterelements auf der Montageoberfläche erreicht werden. So ist es zum Beispiel möglich, dass die elektrische Leitung im Kühlkörper unter dem Halbleiterelement hindurchgeführt wird. Dies ist besonders vorteilhaft, um beispielsweise Kreuzungen von elektrischen Leitungen vermeiden oder reduzieren zu können.

Bezüglich der Herstellung des Halbleitermoduls wird ferner vorgeschlagen, dass der Kühlkörper gemeinsam mit der wenigstens einen elektrischen Leitung in einem additiven Fertigungsprozess hergestellt wird. Dadurch ist es möglich, die wenigstens eine elektrische Leitung in hochflexibler Weise in den Kühlkörper, unterhalb der Montageoberfläche des Kühlkörpers, anzuordnen. Auf diese Weise können dem Grunde nach auch Kreuzungen von elektrischen Leitungen realisiert sein.

Weiterhin wird vorgeschlagen, dass zunächst die wenigstens eine Nut in den Kühlkörper und anschließend die wenigstens eine elektrische Leitung mittels des additiven Fertigungsprozesses eingebracht wird. Bei dieser Weiterbildung wird zunächst der Kühlkörper mit der wenigstens einen Nut bereitgestellt und lediglich die wenigstens eine elektrische Leitung mittels des additiven Fertigungsprozesses eingebracht. Diese Verfahrensführung erweist sich hinsichtlich der Kosten und der Flexibilität als besonders vorteilhaft. Es braucht nämlich nicht der vollständige Kühlkörper mittels des additiven Fertigungsprozesses hergestellt zu werden. Dadurch kann der additive Fertigungsprozess sehr einfach und kostengünstig realisiert sein. Die Nut kann beispielsweise mittels eines spanabhebenden Verfahrens in den Kühlkörper eingebracht sein.

Darüber hinaus wird vorgeschlagen, dass vor dem Einbringen der wenigstens einen elektrischen Leitung in die wenigstens eine Nut eine Schicht aus einem elektrisch isolierenden Werkstoff mittels des additiven Fertigungsprozesses in die Nut eingebracht wird. Die Schicht kann zumindest teilweise an Wänden der Nut angebracht sein. Vorzugsweise bedeckt die Schicht die Wände der wenigstens einen Nut vollständig. Diese Verfahrensführung erlaubt es, die elektrisch isolierende Schicht sehr spezifisch und individuell angepasst ausbilden zu können. Dadurch kann beispielsweise Bauraum eingespart werden.

Gemäß einer Weiterbildung wird vorgeschlagen, dass die Montageoberfläche bearbeitet wird, um zumindest im Bereich der Anordnung des wenigstens einen Halbleiterelements eine einzige plane Fläche auszubilden. Dadurch kann eine im Wesentlichen homogene glatte Oberfläche erreicht werden, die eine weitgehende Anordnungsfreiheit bezüglich der Positionierung des wenigstens einen Halbleiterelements erlaubt. Die Flexibilität kann somit weiter verbessert werden.

Die für den erfindungsgemäßen Kühlkörper angegebenen Vorteile und Wirkungen gelten natürlich gleichermaßen auch für das erfindungsgemäße Halbleiterelement sowie das erfindungsgemäße Verfahren und umgekehrt. Insbesondere können daher Vorrichtungsmerkmale auch verfahrenstechnisch und umgekehrt formuliert sein.

Bei den im Folgenden erläuterten Ausführungsbeispielen handelt es sich um bevorzugte Ausführungsformen der Erfindung.

Es zeigen:
- FIG 1: eine schematisch-perspektivische Ansicht eines Halbleitermoduls des Stands der Technik,
- FIG 2: eine schematische Schnittansicht eines Halbleitermoduls mit einem integrierten Kühlkörper und teilweise in den Kühlkörper integrierten elektrischen Leitungen,
- FIG 3: eine schematische Draufsicht auf eine Montageoberfläche des Kühlkörpers des Halbleitermoduls gemäß FIG 2, und
- FIG 4: eine weitere Ausgestaltung eines Halbleitermoduls basierend auf FIG 3, jedoch mit drei Halbleiterelementen.

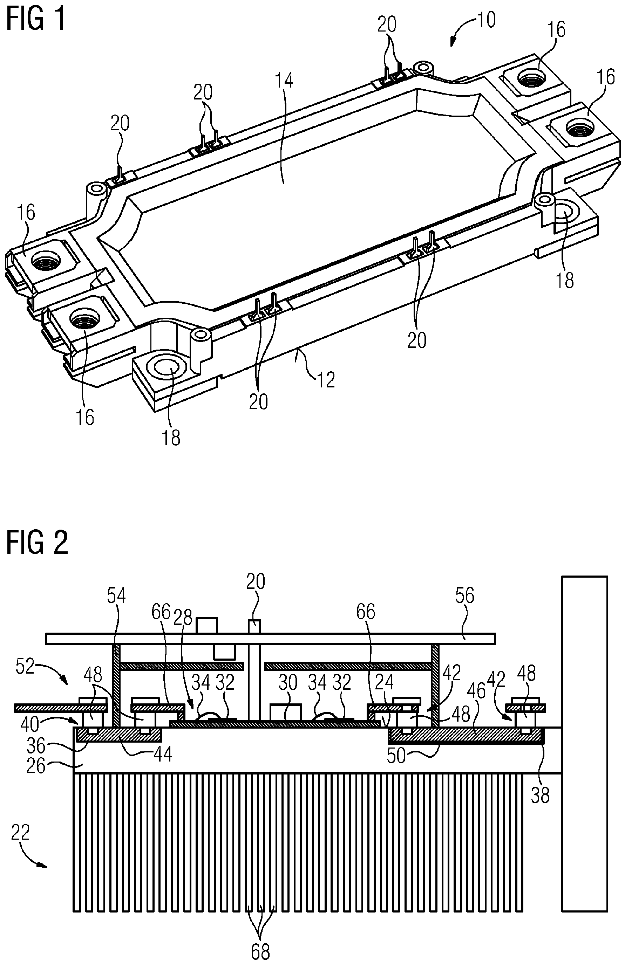

FIG 1 zeigt in einer schematisch-perspektivischen Ansicht ein Halbleitermodul 10, auch Leistungsmodul genannt, welches zur Bereitstellung von Schaltelementen für einen nicht dargestellten Wechselrichter dient. Das Halbleitermodul 10 umfasst eine Kühlfläche 12, die der Verbindung mit einem nicht dargestellten Kühlkörper, nämlich dessen Montageoberfläche, dient.

Das Halbleitermodul 10 umfasst ferner ein Gehäuse 14, das mit der Kühlfläche 12 mechanisch verbunden ist und einen nicht dargestellten Innenraum bereitstellt, in dem in ebenfalls nicht dargestellter Weise mehrere Halbleiterelemente angeordnet sind und thermisch an die Kühlfläche 12 angekoppelt sind. Das Gehäuse 14 ist im Wesentlichen rechteckförmig ausgebildet und stellt an seinen vier Ecken jeweilige Montagehülsen 18 bereit, mittels denen das Halbleitermodul 10 am Kühlkörper sowie an einer nicht dargestellten Leiterplatte befestigt werden kann. Zu diesem Zweck ist eine entsprechende Schraubverbindung vorgesehen.

Der Kühlfläche 12 gegenüberliegend ragen aus dem Gehäuse 14 Anschlussfahnen 20 heraus, die in entsprechende Durchgangsöffnungen der Leiterplatte eingeführt werden können. Vorliegend ist vorgesehen, dass diese Anschlussfahnen 20 in den entsprechenden Durchgangsöffnungen der Leiterplatte verlötet werden. Die Anschlussfahnen 20 dienen dazu, für das Halbleitermodul 10 entsprechende Steuersignale sowie Messsignale bereitzustellen, die für dessen bestimmungsgemäßen Betrieb erforderlich sind.

Das Gehäuse 14 umfasst ferner an schmalen gegenüberliegenden Stirnseiten des Gehäuses 14 Anschlusskontakte 16 für große elektrische Ströme, die ebenfalls eine Schraubverbindung bereitstellen. An den Anschlusskontakten 16 können entsprechende Stromschienen mittels Schraubverbindungen angeschlossen werden.

Die Ausgestaltung gemäß FIG 1 erweist sich insofern als nachteilig, als dass die Anschlusskontakte 16 aufgrund der Konstruktion des Halbleitermoduls 10 im Wesentlichen nicht variiert werden können. Dadurch ist ein Aufbau des Wechselrichters unhandlich und kann hinsichtlich der Konstruktion kaum verbessert werden.

FIG 2 zeigt nun eine erste Ausgestaltung eines Halbleitermoduls 52 gemäß der Erfindung, mit dem die vorgenannten Nachteile weitgehend überwunden werden können. Das Halbleitermodul 52 umfasst einen Kühlkörper 22, der eine Kühlkörpergrundplatte 26 aufweist, die an einer Seite eine Montageoberfläche 24 und an der gegenüberliegenden Seite Kühlrippen 68 aufweist. Die Kühlrippen können gemäß der Lehre der EP 3 624 184 A1 nachträglich, das heißt, am Ende eines Herstellprozesses des Halbleitermoduls 52, in dafür vorgesehene Nuten eingebracht und befestigt sein.

Wie aus der schematischen Schnittansicht des Halbleitermoduls 52 gemäß FIG 2 ersichtlich ist, dient die Montageoberfläche 24 zum Anordnen eines Halbleiterelements 28. Die Montageoberfläche 24 weist darüber hinaus zwei offene Nuten 36, 38 auf. In den Nuten 36, 38 sind jeweilige elektrische Leitungen 44, 46 angeordnet. Jede der Leitungen 44, 46 weist einen jeweiligen Anschlussbereich 40, 42 auf, der dem elektrischen Anschluss der jeweiligen elektrischen Leitung 44, 46 dient.

Der Kühlkörper 22 ist vorliegend aus einer Aluminiumlegierung gebildet. In alternativen Ausgestaltungen kann hier jedoch auch ein entsprechender anderer Werkstoff eingesetzt sein, der sich für die vorgesehene Anwendung eignet. Insbesondere kann natürlich auch ein elektrisch isolierender Werkstoff als Werkstoff für den Kühlkörper zum Einsatz kommen, beispielsweise Aluminiumoxid oder dergleichen. Die elektrischen Leitungen 44, 46 sind vorliegend im Wesentlichen aus Kupfer gebildet. In alternativen Ausgestaltungen kann hier jedoch auch ein anderer geeigneter elektrischer leitfähiger Werkstoff zum Einsatz kommen. Beispielsweise kann der Werkstoff Aluminium, eine Aluminiumlegierung, Silber, eine Silberlegierung und/oder dergleichen sein.

Aus FIG 2 ist ersichtlich, dass die elektrischen Leitungen 44, 46 die jeweiligen Nuten 36, 38 im Wesentlichen vollständig ausfüllen. Darüber hinaus schließen die elektrischen Leitungen 44, 46 bündig mit der Montageoberfläche 24 ab. Dadurch kann eine einheitliche homogene glatte plane Oberfläche erreicht werden. Dem Grunde nach ist es dadurch also auch möglich, die Montageoberfläche 24 im Bereich der jeweiligen Nuten 36, 38 zu nutzen.

Außenabmessungen der elektrischen Leitungen 44, 46 sind vorliegend im Wesentlichen vollständig an Innenabmessungen der jeweiligen Nuten 36, 38 angepasst ausgebildet.

Wie aus FIG 2 ersichtlich ist, kontaktiert die elektrische Leitung 44 über die Nut 36 die Kühlkörpergrundplatte 26 des Kühlkörpers 22. Im vorliegenden Fall ist hier eine elektrische Isolation nicht erforderlich, weil sowohl der Kühlkörper als auch die elektrische Leitung 44 auf dem gleichen elektrischen Potential sind.

Dagegen ist in der Nut 38 vorgesehen, dass die Nut 38 an ihrer Oberfläche eine elektrisch isolierende Schicht 50 aufweist. Die elektrisch isolierende Schicht 50 ist vorliegend durch eine galvanische Schicht gebildet, die zum Beispiel aus Aluminiumoxid oder dergleichen gebildet sein kann. Die Dicke der elektrisch isolierenden Schicht 50 ist vorliegend geeignet gewählt, dass sie im bestimmungsgemäßen Betrieb des Halbleitermoduls 52 eine ausreichende elektrische Isolation bereitzustellen vermag. In dieser Ausgestaltung ist nämlich vorgesehen, dass die elektrische Leitung 46 auf einem deutlich anderen elektrischen Potential als der Kühlkörper 22, insbesondere seine Kühlkörpergrundplatte 26, ist.

Dem Grunde nach besteht natürlich auch die Möglichkeit, dass die elektrischen Leitungen 44, 46 selbst eine elektrisch isolierende Schicht aufweisen. Dies kann natürlich auch mit der elektrisch isolierenden Schicht 50 kombiniert sein. Dadurch kann erreicht werden, dass auch montageoberflächenseitig eine elektrische Isolation bereitgestellt sein kann. Dies ist insbesondere vorteilhaft, wenn der Bereich der elektrischen Leitungen 44, 46 zum Anordnen von Bauteilen genutzt werden können soll.

Je nach Bedarf kann natürlich ergänzend oder alternativ auch noch vorgesehen sein, dass zwischen der jeweiligen elektrischen Leitung 44, 46 und der jeweiligen Nut 36, 38 ein elektrisches Isolationselement angeordnet sein kann. Das elektrische Isolationselement kann ein separat handhabbares Bauteil sein, welches vor dem Anordnen der elektrischen Leitungen 44, 46 in den jeweiligen Nuten 36, 38 angeordnet werden kann. Das elektrische Isolationselement kann zum Beispiel ein Kunststoffteil, ein Keramikteil oder dergleichen sein.

In der vorliegenden Ausgestaltung ist ferner vorgesehen, dass die elektrisch isolierende Schicht 50 bündig mit der Montageoberfläche 24 abschließt. Dadurch besteht hinsichtlich der Montageoberfläche 24 eine große Flexibilität, weil Überstände, die aus der Montageoberfläche 24 herausragen, vermieden sind.

Aus FIG 2 ist weiterhin ersichtlich, dass die elektrischen Leitungen 44, 46 jeweilige Anschlussbereiche 40, 42 aufweisen, an denen elektrische Anschlussbolzen 48 mittels Schraubbefestigung unmittelbar an den entsprechenden elektrischen Leitungen 44, 46 befestigt sind.

In einem mittleren Bereich der Montageoberfläche 24, der vorliegend von den Nuten 36, 38 freigehalten ist, ist ein Halbleiterelement 28 angeordnet. Das Halbleiterelement 28 umfasst ein Substrat 30, auf welchem Halbleiterchips beziehungsweise Halbleiterkristalle 32 befestigt sind. Diese sind vorliegend auf dem Substrat 30 aufgelötet. Mittels Bonddrähten 34 sind die Halbleiterchips 32 mit in FIG 2 nicht dargestellten elektrischen Leitungen verbunden. Über Anschlussleitungen 66 ist das Halbleiterelement 28 an jeweilige der Anschlussbolzen 48 angeschlossen. Vorliegend ist hier eine Schraubverbindung vorgesehen. An weiteren Anschlussbolzen 48 können ergänzende Leitungen angeschlossen sein.

Darüber hinaus ist am Halbleiterelement 28 eine Anschlussfahne 20 angeordnet, wie sie auch bereits anhand von FIG 1 erläutert worden ist. Über diese Anschlussfahne 20 kann ein entsprechendes Steuersignal für die durch die Halbleiterchips 32 bereitgestellten Halbleiterschaltelemente bereitgestellt werden.

Zu erkennen ist ferner, dass der Bereich des Halbleiterelements 28 inklusive der entsprechend zugeordneten Anschlussbolzen 48 von einem Rahmen 54 umgeben ist. Der Rahmen 54 ist auf der Montageoberfläche 24 befestigt, beispielsweise mittels Kleben, Verschweißen oder dergleichen. Der Rahmen 54 besteht vorliegend aus einem Kunststoff. Der Rahmen ist in der Regel aus einem elektrisch isolierenden Werkstoff gebildet.

Die Anschlussfahne 20 ragt durch den Rahmen 54 hindurch. In dieser Ausgestaltung ist vorgesehen, dass der durch den Rahmen 54 bereitgestellte Hohlraum mit einem Vergussmaterial, beispielsweise Epoxy, ausgefüllt wird. Dadurch sind das Halbleiterelement 28 und seine Anschlüsse vor äußeren Einwirkungen geschützt.

Auch wenn in der vorliegenden Ausgestaltung vorgesehen ist, dass das Halbleiterelement 28 außerhalb des Bereichs der elektrischen Leitungen 44, 46 angeordnet ist, kann vorgesehen sein, dass die Montageoberfläche 24 nach Einbringen der elektrischen Leitungen 44, 46 bearbeitet wird, beispielsweise durch Fräsen oder dergleichen, um zumindest im Bereich der Anordnung des wenigstens einen Halbeleiterelements 28 eine einzige plane Fläche auszubilden. Dadurch kann auch erreicht werden, dass das Halbleiterelement 28 unter Umständen auch im Bereich zumindest einer der beiden elektrischen Leitungen 44, 46 angeordnet werden darf. Dadurch kann eine weitere Flexibilität durch die Erfindung erreicht werden.

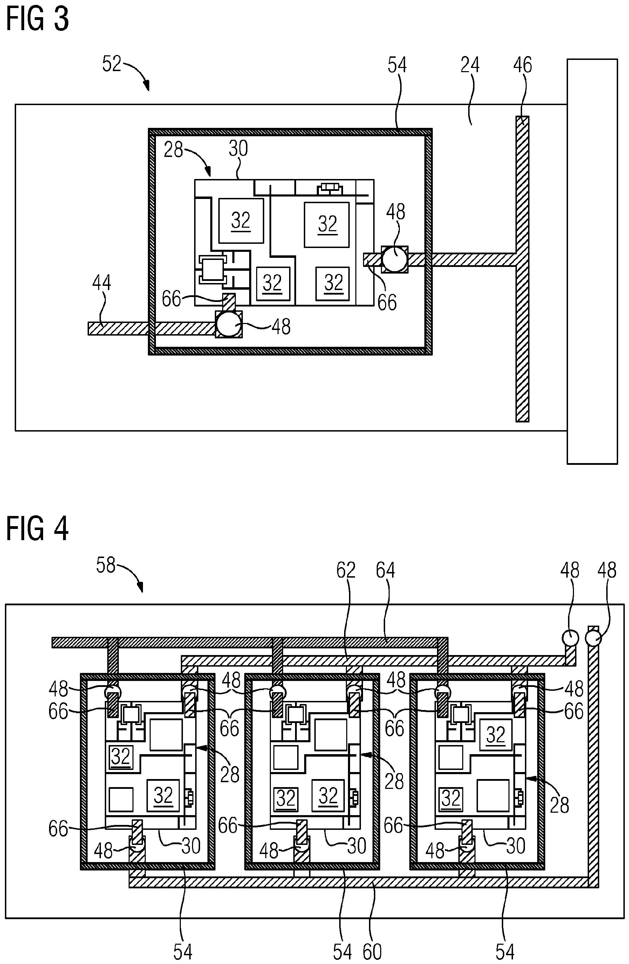

FIG 3 zeigt in einer schematischen Draufsicht das Halbleitermodul 52 gemäß FIG 2. Bezüglich der Details wird auf die voranstehenden detaillierten Erläuterungen verwiesen.

Zu erkennen ist ferner in FIG 2, dass die Anschlussfahne 20 die Leiterplatte 56 in einer Durchgangsbohrung durchragt. Dadurch kann auf einfache Weise ein elektrischer Anschluss realisiert werden, indem die Anschlussfahne 20 in der entsprechenden Durchkontaktierung verlötet wird.

FIG 4 zeigt ein weiteres Halbleitermodul 58, welches dem Grunde nach auf dem Halbleitermodul 52 gemäß FIG 2, 3 basiert. Im Unterschied zur Ausgestaltung gemäß FIG 2 und 3 weist das Halbleitermodul 58 gemäß FIG 4 drei Halbleiterelemente 28 auf, die jeweils dem Halbleiterelement 28 gemäß der FIG 2 und 3 im Wesentlichen entsprechen.

Zu erkennen ist in FIG 4, dass eine elektrische Leitung 62, die ebenfalls im Kühlkörper 22 angeordnet ist, der Zuführung eines positiven Zwischenkreispotentials eines Gleichspannungszwischenkreises dient. Die elektrische Leitung 60 dient dagegen zur Zuführung eines entsprechend negativen Zwischenkreispotentials. Die drei Halbleiterelemente 28 sind somit parallelgeschaltet an einen nicht weiter bezeichneten Gleichspannungszwischenkreis angeschlossen. In FIG 4 sind die hierfür erforderlichen weiteren Anschlussbolzen 48 nicht dargestellt. Insbesondere im Bereich des Rahmens 54 sind die elektrischen Leitungen 60, 62, 64 in den Kühlkörper 22 integriert ausgebildet. Über die elektrische Leitung 64, die außerhalb des Rahmens 54 vorliegend nicht in den Kühlkörper 22 integriert ist, kann ein entsprechender Abgang zum Bereitstellen einer Wechselspannung erreicht werden.

In der vorliegenden Ausgestaltung ist somit vorgesehen, dass die drei Halbleiterelemente 28 im Wesentlichen parallelgeschaltet sind. Diese Ausgestaltung eignet sich daher dazu, ein Schaltelement für einen Wechselrichter mit großer Leistung bereitzustellen. Dabei ist ferner vorgesehen, dass jedes Halbleiterelement 28 einen eigenen Rahmen 54 aufweist, der entsprechend mit Vergussmasse befüllt ist. Bezüglich dieser weiteren Merkmale dieser Ausgestaltung wird ergänzend auf die Ausführungen zu den FIG 2 und 3 verwiesen.

Durch die erfindungsgemäße Konstruktion, das heißt, das Einbinden zumindest einer Verdrahtungsebene in eine Kühlkörpergrundplatte 26, kann nicht nur eine erhebliche Reduzierung des Bauraums erreicht werden, sondern es ermöglicht darüber hinaus auch eine hochflexible Anordnung von Anschlusskontakten wie den Anschlusskontakten 16 in FIG 1. Dadurch kann die Flexibilität erheblich vergrößert werden.

Wie aus FIG 2 nämlich ersichtlich ist, kann dem Kühlkörper 22 gegenüberliegend eine Leiterplatte 56 unmittelbar angeordnet sein, ohne dass hierzu irgendwelche Befestigungsbohrungen in der Leiterplatte vorgesehen zu werden bräuchten. Dadurch kann auch die Nutzung der Leiterplatte 56 erheblich verbessert werden.

Verfahrenstechnisch ist vorliegend vorgesehen, dass zunächst der Kühlkörper 22 mit seiner Montageoberfläche 24 und mit den Nuten 36, 38 bereitgestellt wird. Sodann wird das Halbleiterelement 28 mit der Montageoberfläche 24 durch Löten verbunden. Anschließend werden entsprechende Kupfereinlagen für die elektrischen Leitungen 44, 46 in die jeweiligen Nuten 36, 38 eingelegt. Beispielsweise kann vorgesehen sein, dass die Kupfereinlagen lediglich im Bereich der Anschlussbereiche 40, 42 isolationsfrei sind und ansonsten eine elektrische Isolationsschicht aufweisen. Beispielsweise können die Kupfereinlagen mittels eines Bügels eingeschraubt werden. Sie werden dann fest mit dem Kühlkörper 22 innerhalb der jeweiligen Nut 36, 38 verbunden.

Sodann wird der das Halbleiterelement 28 umfassende Rahmen 54 auf die Montageoberfläche 24 geklebt. Der Kleber kann zugleich dazu dienen, eine Dichtungsfunktion bereitzustellen, insbesondere im Bereich der elektrischen Leitungen 44, 46. Mittels einer Kontaktierungsvorrichtung kann das Halbleiterelement 28 an die elektrischen Leitungen 44, 46 angeschlossen werden. Dies kann mittels Schrauben, Ultraschallschweißen und/oder dergleichen erfolgen. Schließlich wird ein Vergussmaterial in den Rahmen 54 eingebracht. Somit ist das Halbleitermodul 52 nun fertiggestellt.

Alternativ oder ergänzend kann auch vorgesehen sein, dass der Kühlkörper 22 mittels eines additiven Herstellverfahrens hergestellt wird. Zu diesem Zweck werden zunächst die Nuten 36, 38 beispielsweise in den Kühlkörper 22 gefräst. Die Herstellung der elektrisch isolierenden Schicht 50 kann durch Aufsprühen einer Isolationslage, zum Beispiel durch Aufbringen von einem Keramikwerkstoff, mittels eines Coldspray-Verfahrens erfolgen. Anschließend kann der Werkstoff der elektrischen Leitungen 44, 46 ebenfalls mittels eines Coldspray-Verfahrens aufgetragen werden. Schließlich kann die Montageoberfläche 24 plangefräst und vernickelt werden. Sodann kann das Halbleiterelement 28, insbesondere sein Substrat 30, auf die Kühlkörperoberfläche beziehungsweise Montageoberfläche 24 gelötet werden. Schließlich wird wieder der Rahmen 54 auf die Montageoberfläche 24 im Bereich des Halbleiterelements 28 geklebt und, wie zuvor erläutert, die elektrische Kontaktierung beziehungsweise der elektrische Anschluss realisiert. Auch hier wird abschließend Vergussmaterial in den Rahmen 54 eingebracht.

Die Ausführungsbeispiele dienen ausschließlich der Erläuterung der Erfindung und sollen diese nicht beschränken.

## Patentansprüche

1. Kühlkörper (22) mit einer Montageoberfläche (24) zum Anordnen von wenigstens einem Halbleiterelement (28), wobei in der Montageoberfläche (24) wenigstens eine offene Nut (36, 38) ausgebildet ist,
wobei wenigstens eine wenigstens einen Anschlussbereich (40, 42) zum Anschließen des wenigstens einen Halbleiterelements (28) aufweisende elektrische Leitung (44, 46), die zumindest teilweise in der wenigstens einen Nut (36, 38) angeordnet ist,
**dadurch gekennzeichnet, dass** die Nut (38) an ihrer Oberfläche eine elektrisch isolierende Schicht (50) aufweist.

2. Kühlkörper (22) mit einer Montageoberfläche (24) zum Anordnen von wenigstens einem Halbleiterelement (28), wobei in der Montageoberfläche (24) wenigstens eine offene Nut (36, 38) ausgebildet ist,
wobei wenigstens eine wenigstens einen Anschlussbereich (40, 42) zum Anschließen des wenigstens einen Halbleiterelements (28) aufweisende elektrische Leitung (44, 46), die zumindest teilweise in der wenigstens einen Nut (36, 38) angeordnet ist,
**dadurch gekennzeichnet, dass** die wenigstens eine elektrische Leitung (44, 46) eine elektrisch isolierende Schicht aufweist.

3. Kühlkörper (22) mit einer Montageoberfläche (24) zum Anordnen von wenigstens einem Halbleiterelement (28), wobei in der Montageoberfläche (24) wenigstens eine offene Nut (36, 38) ausgebildet ist,
wobei wenigstens eine wenigstens einen Anschlussbereich (40, 42) zum Anschließen des wenigstens einen Halbleiterelements (28) aufweisende elektrische Leitung (44, 46), die zumindest teilweise in der wenigstens einen Nut (36, 38) angeordnet ist,
**dadurch gekennzeichnet, dass** zwischen der wenigstens einen Nut (36, 38) und der wenigstens einen elektrischen Leitung (44, 46) zumindest teilweise ein elektrisches Isolationselement angeordnet ist.

4. Kühlkörper nach einem der vorhergehenden Ansprüche, **dadurch gekennzeichnet, dass** der Anschlussbereich (40, 42) wenigstens eine Kontaktfläche oder ein Anschlusskontaktelement (48) aufweist.

5. Kühlkörper nach einem der vorhergehenden Ansprüche, **dadurch gekennzeichnet, dass** die elektrische Leitung (44, 46) zumindest teilweise bündig mit der Montageoberfläche (24) abschließt.

6. Kühlkörper nach einem der vorhergehenden Ansprüche, **dadurch gekennzeichnet, dass** Außenabmessungen der wenigstens einen elektrischen Leitung (44, 46) zumindest teilweise an Innenabmessungen der wenigstens einen Nut (36, 38) angepasst ausgebildet sind.

7. Kühlkörper nach einem der vorhergehenden Ansprüche, **dadurch gekennzeichnet, dass** das Isolationselement und/oder die elektrisch isolierende Schicht (50) zumindest teilweise bündig mit der Montageoberfläche (24) abschließt.

8. Kühlkörper nach einem der vorhergehenden Ansprüche, **dadurch gekennzeichnet, dass** das Isolationselement und/oder die elektrisch isolierende Schicht (50) aus einem thermisch gut leitfähigen Werkstoff gebildet ist.

9. Halbleitermodul (52) für einen elektrischen Energiewandler mit einem Kühlkörper (22) und einem auf einer Montageoberfläche (24) des Kühlkörpers (22) angeordneten Halbleiterelement (28),
**dadurch gekennzeichnet, dass**
der Kühlkörper (22) nach einem der vorhergehenden Ansprüche ausgebildet ist und das Halbleiterelement (28) an die wenigstens eine elektrische Leitung (44, 46) des Kühlkörpers (22) angeschlossen ist.

10. Halbleitermodul nach Anspruch 9, **dadurch gekennzeichnet, dass** das Halbleiterelement (28) zumindest teilweise im Bereich der elektrischen Leitung (44, 46) angeordnet ist.

11. Verfahren zum Herstellen eines Halbleitermoduls (52), wobei:
- ein Kühlkörper (22) mit einer Montageoberfläche (24) zum Anordnen von wenigstens einem Halbleiterelement (28) und mit wenigstens einer in der Montageoberfläche (24) eingebrachten Nut (36, 38) bereitgestellt wird,
- das wenigstens eine Halbleiterelement (28) mit der Montageoberfläche verbunden wird,
- die wenigstens eine elektrische Leitung (44, 46) in die wenigstens eine Nut (36, 38) eingebracht wird,
- ein das wenigstens eine Halbleiterelement (28) umfassender Rahmen (54) auf der Montageoberfläche (24) angeordnet wird,
- das wenigstens eine Halbleiterelement (28) an die wenigstens eine elektrische Leitung (44, 46) angeschlossen wird, und
- im Rahmen (54) eine Vergussmasse angeordnet wird.

12. Verfahren nach Anspruch 11, **dadurch gekennzeichnet, dass** der Kühlkörper (22) gemeinsam mit der wenigstens einen elektrischen Leitung (44, 46) in einem additiven Fertigungsprozess hergestellt wird.

13. Verfahren nach einem der Ansprüche 11 oder 12, **dadurch gekennzeichnet, dass** zunächst die wenigstens eine Nut (36, 38) in den Kühlkörper (22) und anschließend die wenigstens eine elektrische Leitung (44, 46) mittels des additiven Fertigungsprozesses eingebracht wird.

14. Verfahren nach Anspruch 13, **dadurch gekennzeichnet, dass** vor dem Einbringen der wenigstens einen elektrischen Leitung (44, 46) in die Nut (36, 38) eine Schicht (50) aus einem elektrisch isolierenden Werkstoff mittels des additiven Fertigungsprozesses in die Nut (36, 38) eingebracht wird.

15. Verfahren nach einem der Ansprüche 11 bis 14, **dadurch gekennzeichnet, dass** die Montageoberfläche (24) bearbeitet wird, um zumindest im Bereich der Anordnung des wenigstens einen Halbleiterelements (28) eine einzige plane Fläche auszubilden.

## Claims

1. Heat sink (22) having a mounting surface (24) for arranging at least one semiconductor element (28), wherein at least one open groove (36, 38) is embodied in the mounting surface (24), wherein at least one electrical line (44, 46) having at least one connection region (40, 42) for connecting the at least one semiconductor element (28) and being at least in part arranged in the at least one groove (36, 38),
**characterised in that** the groove (38) has an electrically insulating layer (50) on its surface.

2. Heat sink (22) having a mounting surface (24) for arranging at least one semiconductor element (28), wherein at least one open groove (36, 38) is embodied in the mounting surface (24),
wherein at least one electrical line (44, 46) having at least one connection region (40, 42) for connecting the at least one semiconductor element (28) and being at least in part arranged in the at least one groove (36, 38),
**characterised in that** the at least one electrical line (44, 46) has an electrically insulating layer.

3. Heat sink (22) having a mounting surface (24) for arranging at least one semiconductor element (28), wherein at least one open groove (36, 38) is embodied in the mounting surface (24), wherein at least one electrical line (44, 46) having at least one connection region (40, 42) for connecting the at least one semiconductor element (28) and being at least in part arranged in the at least one groove (36, 38),
**characterised in that** an electrical insulation element is at least in part arranged between the at least one groove (36, 38) and the at least one electrical line (44, 46).

4. Heat sink according to one of the preceding claims, **characterised in that** the connection region (40, 42) has at least one contact surface or one connection contact element (48) .

5. Heat sink according to one of the preceding claims, **characterised in that** the electrical line (44, 46) terminates at least partially flush with the mounting surface (24).

6. Heat sink according to one of the preceding claims, **characterised in that** external dimensions of the at least one electrical line (44, 46) are embodied at least to some extent matched to internal dimensions of the at least one groove (36, 38) .

7. Heat sink according to one of the preceding claims, **characterised in that** the insulation element and/or the electrically insulating layer (50) terminate/terminates at least partially flush with the mounting surface (24).

8. Heat sink according to one of the preceding claims, **characterised in that** the insulation element and/or the electrically insulating layer (50) are/is formed from a thermally highly conductive material.

9. Semiconductor module (52) for an electrical energy converter having a heat sink (22) and a semiconductor element (28) arranged on a mounting surface (24) of the heat sink (22),
**characterised in that**
the heat sink (22) is embodied according to one of the preceding claims and the semiconductor element (28) is connected to the at least one electrical line (44, 46) of the heat sink (22).

10. Semiconductor module according to claim 9, **characterised in that** the semiconductor element (28) is arranged at least in part in the region of the electrical line (44, 46).

11. Method for producing a semiconductor module (52), wherein:
- a heat sink (22) is provided having a mounting surface (24) for arranging at least one semiconductor element (28) and having at least one groove (36, 38) incorporated in the mounting surface (24),
- the at least one semiconductor element (28) is connected to the mounting surface,
- the at least one electrical line (44, 46) is inserted into the at least one groove (36, 38),
- a frame (54) comprising the at least one semiconductor element (28) is arranged on the mounting surface (24),
- the at least one semiconductor element (28) is connected to the at least one electrical line (44, 46), and
- a potting compound is arranged in the frame (54).

12. Method according to claim 11, **characterised in that** the heat sink (22) is produced together with the at least one electrical line (44, 46) in an additive manufacturing process.

13. Method according to one of claims 11 or 12, **characterised in that** firstly the at least one groove (36, 38) is incorporated into the heat sink (22) and then the at least one electrical line (44, 46) is inserted by means of the additive manufacturing process.

14. Method according to claim 13, **characterised in that** before the at least one electrical line (44, 46) is inserted into the groove (36, 38), a layer (50) composed of an electrically insulating material is incorporated into the groove (36, 38) by means of the additive manufacturing process.

15. Method according to one of claims 11 to 14, **characterised in that** the mounting surface (24) is machined in order to form a single flat surface at least in the region in which the at least one semiconductor element (28) is arranged.

## Revendications

1. Puits (22) de chaleur ayant une surface (24) de montage pour le montage d'au moins un élément (28) à semiconducteur, dans lequel dans la surface (24) de montage est constituée au moins une rainure (36, 38) ouverte,
dans lequel au moins une ligne (44, 46) électrique ayant au moins une partie (40, 42) de connexion pour la connexion du au moins un élément (28) à semiconducteur est disposée au moins en partie dans la au moins une rainure (36, 38),
**caractérisé en ce que** la rainure (38) a, sur sa surface, une couche (50) isolante du point de vue électrique.

2. Puits (22) de chaleur ayant une surface (24) de montage pour le montage d'au moins un élément (28) à semiconducteur, dans lequel dans la surface (24) de montage est constituée au moins une rainure (36, 38) ouverte,
dans lequel au moins une ligne (44, 46) électrique ayant au moins une partie (40, 42) de connexion pour la connexion du au moins un élément (28) à semiconducteur est disposée au moins en partie dans la au moins une rainure (36, 38),
**caractérisé en ce que** la au moins une ligne (44, 46) électrique a une couche isolante du point de vue électrique.

3. Puits (22) de chaleur ayant une surface (24) de montage pour le montage d'au moins un élément (28) à semiconducteur, dans lequel dans la surface (24) de montage est constituée au moins une rainure (36, 38) ouverte,
dans lequel au moins une ligne (44, 46) électrique ayant au moins une partie (40, 42) de connexion pour la connexion du au moins un élément (28) à semiconducteur est disposée au moins en partie dans la au moins une rainure (36, 38),
**caractérisé en ce qu'**un élément isolant du point de vue électrique est disposé au moins en partie entre la au moins une rainure (36, 38) et la au moins une ligne (44, 46) électrique.

4. Puits de chaleur suivant l'une des revendications précédentes,
**caractérisé en ce que** la partie (40, 42) de connexion a au moins une surface de contact ou un élément (48) de contact de connexion.

5. Puits de chaleur suivant l'une des revendications précédentes,
**caractérisé en ce que** la ligne (44, 46) électrique est au moins en partie au ras de la surface (24) de montage.

6. Puits de chaleur suivant l'une des revendications précédentes,
**caractérisé en ce que** des dimensions extérieures de la au moins une ligne (44, 46) électrique sont constituées de manière adaptée au moins en partie à des dimensions intérieures de la au moins une rainure (36, 38) .

7. Puits de chaleur suivant l'une des revendications précédentes,
**caractérisé en ce que** l'élément isolant et/ou la couche (50) isolante du point de vue électrique sont au moins en partie au ras de la surface (24) de montage.

8. Puits de chaleur suivant l'une des revendications précédentes,
**caractérisé en ce que**
l'élément isolant et/ou la couche (50) isolante du point de vue électrique sont en un matériau bon conducteur de la chaleur.

9. Module (52) à semiconducteur pour un convertisseur d'énergie électrique comprenant un puits (22) de chaleur et un élément (28) à semiconducteur monté sur une surface (24) de montage du puits (22) de chaleur,
**caractérisé en ce que**
le puits (22) de chaleur est constitué suivant l'une des revendications précédentes et l'élément (28) à semiconducteur est connecté à la au moins une ligne (44, 46) électrique du puits (22) de chaleur.

10. Module à semiconducteur suivant la revendication 9, **caractérisé en ce que** l'élément (28) à semiconducteur est disposé au moins en partie dans la partie de la ligne (44, 46) électrique.

11. Procédé de fabrication d'un module (52) à semiconducteur, dans lequel :
- on se procure un puits (22) de chaleur ayant une surface (24) de montage pour le montage d'au moins un élément (28) à semiconducteur et ayant au moins une rainure (36, 38) ménagée dans la surface (24) de montage,
- on assemble le au moins un élément (28) à semiconducteur à la surface de montage,
- on introduit la au moins une ligne (44, 46) électrique dans la au moins une rainure (36, 38),
- on met un cadre (54) comprenant le au moins un élément (28) à semiconducteur sur la surface (24) de montage,
- on connecte le au moins un élément (28) à semiconducteur à la moins une ligne (44, 46) électrique, et
- on met une masse de coulée dans le cadre (54).

12. Procédé suivant la revendication 11, **caractérisé en ce que** l'on fabrique le puits (22) de chaleur ensemble avec la au moins une ligne (44, 46) électrique suivant un processus de fabrication additive.

13. Procédé suivant l'une des revendications 11 ou 12, **caractérisé en ce que** l'on ménage d'abord la au moins une rainure (36, 38) dans le puits (22) de chaleur et on introduit ensuite la au moins une ligne (44, 46) électrique au moyen du processus de fabrication additive.

14. Procédé suivant la revendication 13, **caractérisé en ce que**, avant l'introduction de la au moins une ligne (44, 46) électrique dans la rainure (36, 38), on introduit une couche (50) en un matériau isolant du point de vue électrique dans la rainure (36, 38) au moyen du processus de fabrication additive.

15. Procédé suivant l'une des revendications 11 à 14, **caractérisé en ce que** l'on usine la surface (24) de montage pour former une surface plane unique au moins dans la partie du montage du au moins un élément (28) à semiconducteur.
